# EUROPEAN PATENT APPLICATION

(11) **EP 1 815 968 A1**
(43) Date of publication of application: **08.08.2007**
(21) Application number: 05806807.3
(22) Date of filing: 18.11.2005
(51) Int. Cl.: B29C 67/20, A61M 15/08, B29C 33/38, B41J 2/135, C12M 1/26, H05K 3/00, B01D 39/16

(54) **PROCESSING METHOD, PROCESSING APPARATUS, AND FINE STRUCTURE PRODUCED BY THE METHOD**

(30) Priority: 22.11.2004 JP 2004337697; 15.02.2005 JP 2005037899
(71) Applicant: Sumitomo Electric Industries, Ltd., Osaka-shi, Osaka 541-0041 (JP)
(72) Inventor: YORITA, Jun, SUMITOMO ELECTRIC INDUSTRIES, LTD., Ako-gun, Hyogo 6781205 (JP); HIRATA, Yoshihiro SUMITOMO ELECTRIC INDUSTRIES LTD, Ako-gun, Hyogo 6781205 (JP)
(74) Representative: Cross, Rupert Edward Blount
(86) International application number: PCT/JP2005/021252
(87) International publication number: WO 2006/054701

(57) **Abstract**

In order to provide a processing method according to which a highly precise microstructure can be easily formed with low manufacturing cost, the present invention is characterized by comprising the steps of: placing a thin film made of a resin (1) between a pressing die (2) and a facing base (3); heating the thin film made of a resin (1) between a pressing die (2) and a facing base (3) to a temperature that is no lower than the temperature at which the resin starts being liquefied; and applying pressure to the thin film made of a resin (1) between a pressing die (2) and a facing base (3) at a temperature that is no lower than the temperature at which the resin starts being liquefied, so that a through hole is formed.

## Description

### Technical Field

The present invention relates to a processing method and a processing apparatus for forming an inexpensive microstructure with high precision by applying heat and pressure to a thin film made of a resin. In addition, the invention relates to a microstructure having high performance, for example, a nozzle for an inkjet printer, a medical nebulizer nozzle, a precise filter for ultramicroscopic filler, a high density printed circuit board and a microlens, that are manufactured in accordance with this method.

### Background Art

In order to manufacture a microscopic part having high performance, such as a nozzle for an inkjet printer and a medical nebulizer nozzle, it is necessary to form a microscopic through-hole in a thin film made of a resin or the like with high precision. As the method for forming a microscopic through-hole, there is a laser processing method. In accordance with this method, a photoresist is formed at a point on a plate where a through-hole is formed, and a mask is formed in the area where the photoresist is not formed on the plate. The mask can block high energy beams, such as lasers, and therefore, the photoresist is removed, and a high energy beam, such as a laser, is radiated through a mask, so that a through-hole is formed in the plate (Japanese Patent Laying-Open No. 6(1994)-122203 (see Patent Document 1)). In accordance with laser processing methods, however, it is necessary to radiate a highly bright laser, and the point to be irradiated must be adjusted with high precision, and therefore, processing apparatuses become very expensive, and in addition, through-holes are formed using a laser in accordance with such processing methods, and therefore, throughput is small.

As the method for forming a thin film made of a resin having a micro scopic through-hole, there is an injection molding method. In accordance with this method, a striking block made of an elastic member, such as a silicone resin, is made to make contact with a portion of the used die where a through-hole is formed, and injection molding is carried out in the state where the striking block makes contact. A microscopic through-hole can be formed using a resin having such high fluidity that it can flow into a gap of several µm in a die. In addition, even in the case where a thin striking die of which the diameter is no greater than 50 µm and which is easily broken is used, the striking block is made of an elastic member, and therefore, does not break at the time of injection molding and is easily released from the molded resin (Japanese Patent Laying-Open No. 2000-71459 (see Patent Document 2)). In accordance with this method, however, the types of resin that can be used are greatly limited, and in addition, when the diameter of the opening of through-holes becomes small and the pitch becomes small, the resistance in the flow path becomes great, due to the striking block that makes contact with the die, and therefore, uniform injection of resin becomes difficult.

As the method for forming a microscopic through-hole in a thin film made of a resin, there is a punching process method. In accordance with this method, a metal film is formed on the surface of a puncher made of ceramic fibers, and discharge is created between the end of the puncher and the surface of the die material. As a result of the discharge, a microscopic through-hole through which the puncher can penetrate into the die material is formed without making the puncher make contact with the die material. After the formation of the die hole, the positional relationship between the die and the puncher does not change, and therefore, the puncher can be inserted into the die hole without fail, and through-holes of which the diameter corresponds to the thickness of punchers can be easily formed in a thin plate in a short period of time (Japanese Patent Laying-Open No. 2004-114228 (see Patent Document 3)). In accordance with this method, however, the diameter of the opening of through-holes that can be formed is determined by the diameter of the ceramic fibers, and therefore, there is a limitation in the miniaturization of the through-holes. In addition, one through-hole is formed using one puncher of which the diameter corresponds to that of the through-hole, and therefore, it is difficult to maintain precision in the pitch of the punchers when respective punchers are assembled in a holder, making efficiency in manufacture poor. Furthermore, maintenance and restoration when a puncher breaks is difficult, making productivity poor.
Patent Document 1: Japanese Patent Laying-Open No. 6(1994)-122203
Patent Document 2: Japanese Patent Laying-Open No. 2000-71459
Patent Document 3: Japanese Patent Laying-Open No. 2004-114228

### Disclosure of the Invention

### Problems to be Solved by the Invention

An object of the present invention is to provide a processing method according to which a highly precise microstructure can be easily formed with low manufacturing cost. Another object is to provide a microstructure of which the form can be controlled with high precision when a pressing die is pressed down a predetermined amount without the microstructure being affected by inconsistency in the thickness of the thin film made of a resin, which is the material.

### Means for Solving the Problems

A processing method according to the present invention is a processing method for a thin film made of a resin according to which a microscopic through-hole is formed in a thin film made of a resin, characterized by including the steps of: placing a thin film made of a resin between a pressing die and a facing base; heating the thin film made of a resin between a pressing die and a facing base to a temperature that is no lower than the temperature at which the resin starts being liquefied; and applying pressure to the thin film made of a resin at a temperature that is no lower than the temperature at which the resin starts being liquefied, so that a through-hole is formed.

It is preferable for the pressing die to be made of a metal or a ceramic, as well as for the facing base to be made of a metal, ceramic, plastic or silicone. It is preferable for the pressing die to have a Vickers hardness of no less than 400. Such a pressing die can be manufactured in accordance with a method including the steps of forming a resin die through lithography, forming a layer made of a metal material on the resin die on a conductive substrate through electroforming, and removing the resin die. In addition, the pressing die can be manufactured in accordance with dicing processing or cutting processing.

It is preferable for the facing base to be made of a material selected from among alumina, aluminum nitride, silicon nitride, silicon carbide and tungsten carbide, and it is preferable for the Young's modulus to be no less than 0.1 GPa and no greater than 300 GPa at the time of heating processing. In addition, it is preferable for the Vickers hardness to be no less than 0.5 times and no greater than 3.0 times the Vickers hardness of the pressing die.

In an appropriate embodiment, the step of placing a thin film made of a resin between a pressing die and a facing base includes the step of fixing the thin film made of a resin on the facing base and the step of placing a pressing die on the fixed thin film made of a resin. Meanwhile, in a desirable embodiment, the step of forming a through-hole has the step of exchanging the used facing base with a new facing base after the formation of a through-hole. In addition, it is preferable for the thin film made of a resin and/or the facing base to be supplied from a reel and wound around a reel. Furthermore, in a desirable embodiment, the sequence of steps, starting from the step of placing a thin film made of a resin, through to the step of heating, and on to the step of forming a through-hole, is carried out in a vacuum.

In a preferable embodiment, the distance between the conductive pressing die and the facing base is detected by measuring the capacitance and/or the electrical resistance of the thin film made of a resin during the formation of a microstructure. In addition, in this embodiment, a conductive facing base or a facing base having a circuit substrate between the facing base and the thin film made of a resin is preferably used.

A processing apparatus according to the present invention is a processing apparatus for forming a microscopic through-hole in a thin film made of a resin, and is characterized by including: a means for placing a thin film made of a resin between a pressing die and a facing base; a means for heating the thin film made of a resin between the pressing die and the facing base to a temperature that is no lower than the temperature at which the resin starts being liquefied; and a means for forming a through-hole by applying pressure to the thin film made of a resin at a temperature that is no lower than the temperature at which the resin starts being liquefied between the pressing die and the facing base.

In a preferable embodiment, the maximum difference in pressure within the surface of the means for forming a through-hole is no greater than +/- 10 % at the time of the application of pressure, and it is preferable for it to cool at least one of the thin film made of a resin, the pressing die and the facing base after the formation of a through-hole. In addition, it is preferable for the means for placing a thin film made of a resin, the means for heating the thin film made of a resin and the means for forming a through-hole in the thin film made of a resin to be placed in a vacuum chamber in the processing apparatus. Furthermore, in a preferable embodiment, the processing apparatus further includes a means for detecting the distance between the conductive pressing die and the facing base by measuring the capacitance and/or the electrical resistance of the thin film made of a resin.

A microstructure according to the present invention is manufactured in accordance with such a processing method, and is useful as, for example, medical nebulizer nozzles, nozzles for inkjet printers, microscopic circuits on high density printed circuit boards, filters for capturing cells and filters for ultramicroscopic fillers.

### Effects of the Invention

According to the present invention, a highly precise ultramicroscopic through-hole can be easily formed in a thin film made of a resin with low manufacturing cost.

### Brief Description of the Drawings

Fig. 1 is a diagram showing the steps in a processing method according to the present invention;
Fig. 2 is a diagram showing the steps in a manufacturing method for a pressing die which is used in the processing method according to the present invention;
Fig. 3 is a diagram showing the steps in a manufacturing method for a pressing die which is used in the processing method according to the present invention;
Fig. 4 is a diagram showing the steps in a manufacturing method for a pressing die which is used in the processing method according to the present invention;
Fig. 5 is a diagram showing the steps in a preferable processing method according to the present invention;
Fig. 6 is a graph showing the change in the capacitance and the electrical resistance according to the present invention; and
Fig. 7 is a diagram showing a processing method according to the present invention in the case where a facing base is provided with a circuit substrate between the facing base and the thin film made of a resin.

### Description of the Reference Signs

1,71: thin film made of resin; 2, 72: pressing die; 3, 73: facing base; 21, 31b: conductive substrate; 22, 32: resist; 23, 33: mask; 25, 35: metal material layer; 74: circuit substrate

### Best Modes for Carrying Out the Invention

### (Processing Method)

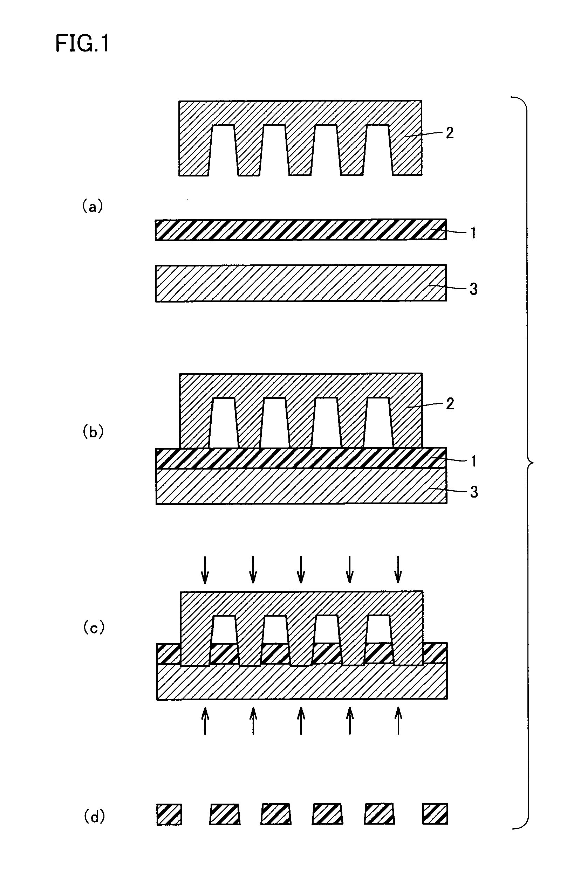

Fig. 1 shows a processing method according to the present invention. This processing method is characterized by being provided with the step of first placing a thin film made of a resin 1 between a pressing die 2 and a facing base 3, as shown in Fig. 1(a), the step of heating thin film made of a resin 1 between pressing die 2 and facing base 3 to a temperature that is no lower than the temperature at which the resin starts being liquefied, and the step of applying pressure to the thin film made of a resin of which the temperature is no lower than the temperature at which the resin starts being liquefied between the pressing die and the facing base, as shown in Fig. 1(c), and thereby, forming a through-hole, as shown in Fig. 1(d).

The thin film made of a resin is heated between the pressing die and the facing base, for example, in a system for heating after placing thin film made of a resin 1 between pressing die 2 and facing base 3 (Fig. 1(b)), in a system for heating only the thin film made of a resin in a state of no contact in advance, or in a system for heating the thin film made of a resin after the film makes contact with the facing base. Thin film made of a resin 1 can be heated using, for example, a heater (not shown) installed directly beneath facing base 3. In addition, the film can be heated if facing base 3 has a heating function inside. In addition, the thin film made of a resin can be heated in advance using a non contact heater or the like during the process of supplying the thin film made of a resin.

The thin film made of a resin is applied by applying pressure after the film is heated to a temperature that is no lower than the temperature at which the resin starts being liquefied, and therefore, highly precise ultramicroscopic through-holes can be easily formed in the thin film made of a resin as a result of the phenomenon where the resin is liquefied, and the manufacturing cost is low. In accordance with the processing method according to the present invention, through-holes of which the diameter is no smaller than 0.1 µm can be formed, though the size may vary, depending on the precision of the used pressing die. In addition, a penetrating line which is a lateral through-hole and has a line width of no smaller than 0.1 µm can also be formed. Accordingly, a microscopic structure having high performance, such as a nozzle for an inkjet printer, a medical nebulizer nozzle, a filter for capturing cells, a filter for ultramicroscopic fillers, a micro lens or a microscopic circuit for a high density printed circuit board can be provided at low cost.

In addition, the processing method according to the present invention can be used for nano imprinting. Nanoimprinting is a method according to which a pressing die having microscopic unevenness at a nano level on the surface is placed on a thin film made of a resin, the thin film made of a resin is heated to a temperature that is no lower than the glass transition temperature, and after that, the pressing die is pressed against the thin film made of a resin and kept in this state for a certain period of time, the thin film made of a resin is cooled to a temperature that is no higher than the glass transition temperature, and then, the pressing die is released from the thin film made of a resin. Nanoimprinting allows the unevenness on the surface of a pressing die to be transcribed onto a thin film made of a resin, is a processing technology based on the same principle as the present invention, can effectively use the processing method according to the present invention, and allows the depth of insertion of the pressing die and the total thickness to be controlled with high precision. In addition, nanoimprinting allows a three-dimensional microscopic form on a sub-micron scale to be easily formed in a simple process, can reduce the manufacturing cost, and makes mass production easy.

It is preferable for the material of the thin film made of a resin to be a resin which is electrically insulating, melts within a relatively narrow temperature range, and hardens quickly when cooled, such as a plastic or resist, from the point of view of high throughput. Accordingly, polycarbonate, polyimide, polymethyl methacrylate (PMMA), polyether sulfone, polysulfone, polyether imide and the like, for example, are appropriate. Though the thickness of the thin film made of a resin is not particularly limited, it is preferable for the thickness to be 1 µm to 10 mm, and it is more preferable for the thickness to be 10 µm to 200 µm. A plate made of a resin having a thickness of several mm or a plastic film having a thickness of several tens of microns, for example, can be used as the material.

In the case where a material having high rigidity is used for the pressing die, and a material of which the rigidity is lower than that of the pressing die, such as a metal or plastic which plastically deforms when pressure is applied by the pressing die, is used for the facing base which is used in such a manner as to face the pressing die, the pressing die can be prevented from being deformed at the time when pressure is applied, and through-holes can be easily formed in a thin film made of a resin, which is preferable. Accordingly, it is preferable for the pressing die to have a Vickers hardness of no less than 400, and it is more preferable for it to have a Vickers hardness of no less than 600.

A ceramic or silicone is used for the facing base, and the pressing die is pressed to the limit against the facing base so as to expel the resin, and thereby, through-holes can be formed. In this case, it is not necessary to frequently exchange the facing base, which is advantageous. It is preferable for the Vickers hardness of the facing base to be no less than 0.5 times the Vickers hardness of the pressing die, and it is more preferable for it to be no less than 0.75 times that of the pressing die. In the case where the hardness is less than 0.5 times that of the pressing die, it becomes difficult to use the facing base a number of times. In addition, it is preferable for the Vickers hardness of the facing base to be no greater than 3.0 times the Vickers hardness of the pressing die, and it is more preferable for it to be no greater than 2.0 times that of the pressing die. In the case where the Vickers hardness of the facing base exceeds 3.0 times that of the pressing die, the pressing die tends to easily break and have a short life.

A metal or a ceramic, for example, is used for the pressing die, and a material made of a metal, ceramic, plastic or silicone can be used for the facing base. In addition, in the case where a material such as alumina, aluminum nitride, silicon nitride, silicon carbide or tungsten carbide is used for the facing base, the thermal conductivity is increased, so that heat transfer becomes smooth at the time of heating or cooling, and thus, the throughput of processing can be increased.

When a metal or a plastic is used facing base, it is preferable for the Young's modulus at the time of heating processing to be no less than 0.1 GPa, and it is more preferable for it to be no less than 1 GPa. In the case where the Young's modulus is less than 0.1 GPa, the facing base deforms together with the thin film made of a resin at the time when pressure is applied, and thus, it tends to become difficult to form a through-hole. In addition, it is preferable for the Young's modulus of the facing base at the time of heating processing to be no greater than 300 GPa, and it is more preferable for it to be no greater than 250 GPa. In the case where the Young's modulus exceeds 300 GPa, the pressing die having a structure with columns of microscopic pillars tends to easily break and have a short life.

When a thin film made of a resin is placed between the pressing die and the facing base, it is preferable to first fix the thin film made of a resin on the facing base, and then, place the pressing die on the fixed thin film made of a resin. In this embodiment, problems, such that the thin film made of a resin is lifted off from the facing base and bubbles are mixed in between the thin film made of a resin and the facing base at the time of placing the thin film made of a resin between the pressing die and the facing base, can be prevented, making the creation of clean holes possible in this process.

A sequence of steps, starting from the step of placing a thin film made of a resin, through to the step of heating, and on to the step of forming a through-hole, is carried out in a vacuum, and thereby, lifting off of the thin film made of a resin from the facing base and mixing in of bubbles between the thin film made of a resin and the facing base can be prevented, making the creation of clean holes possible in this process.

In addition, lifting off of the thin film made of a resin from the facing base and mixing in of bubbles between the thin film made of a resin and the facing base can also be prevented by using a system for supplying the thin film made of a resin and the facing base from a reel and winding these around a reel. Though certain effects are gained by supplying only the thin film made of a resin from a reel, it is more effective to supply both the thin film made of a resin and the facing base together from a reel, and thus, make creation of clean holes easy in the process. The reel-to-reel system is preferable, in that the positional relationship between the thin film made of a resin and the facing base does not change once set. It is possible to supply the thin film made of a resin by, for example, feeding a thick plate in accordance with a batch system.

In the step of forming a through-hole, it is preferable to exchange the used facing base with a new facing base after the formation of a through-hole. In the case where a metal or a plastic is used for the facing base and pressure is applied to the thin film made of a resin between the pressing die and the facing base, a through-hole is formed, and at the same time, the surface of the facing base plastically changes in form as a result of the pressure from the pressing die. Accordingly, the facing base is replaced with a new facing base having a flat surface, and therefore, a highly precise through-hole can be formed. The facing base may have a two-layer structure of a base layer and a thin facing base layer on this base layer, and only the thin facing base layer that has been plastically deformed may be replaced after the formation of a through-hole by applying pressure, which has the same effects as those above. In addition, it is preferable for the conditions for applying pressure between the pressing die and the facing base to be no less than 1 MPa, from the point of view of suppressing the creation of incomplete through-holes, and it is more preferable for the conditions for applying pressure between the pressing die and the facing base to be no less than 3 MPa. Meanwhile, it is preferable for the conditions for applying pressure between the pressing die and the facing base to be no greater than 60 MPa, from the point of view of preventing the pressing die and the facing base from breaking or deforming, and it is more preferable for the conditions for applying pressure between the pressing die and the facing base to be no greater than 40 MPa.

The pressing die can be fabricated in accordance with a method that includes the step of forming a resin die through lithography, the step of forming a layer made of a metal material on the resin die on a conductive substrate through electroforming, and the step of removing the resin die. The fabricated pressing die is a precise metal microstructure, and therefore, through-holes having an ultramicroscopic diameter can be formed in a thin film made of a resin, and the pitch of the through-holes can be made sufficiently small. In addition, the pressing die can be manufactured with high reproducibility, and one-piece molding is possible.

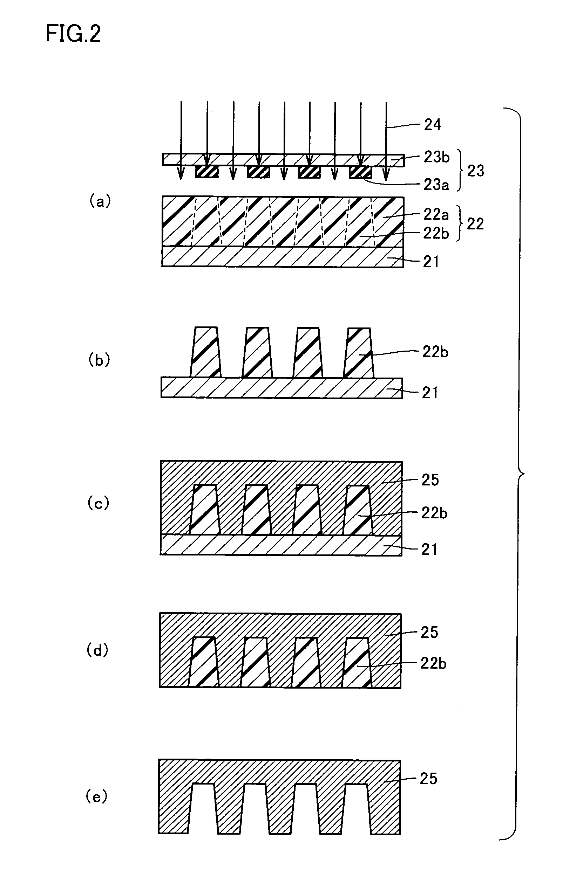

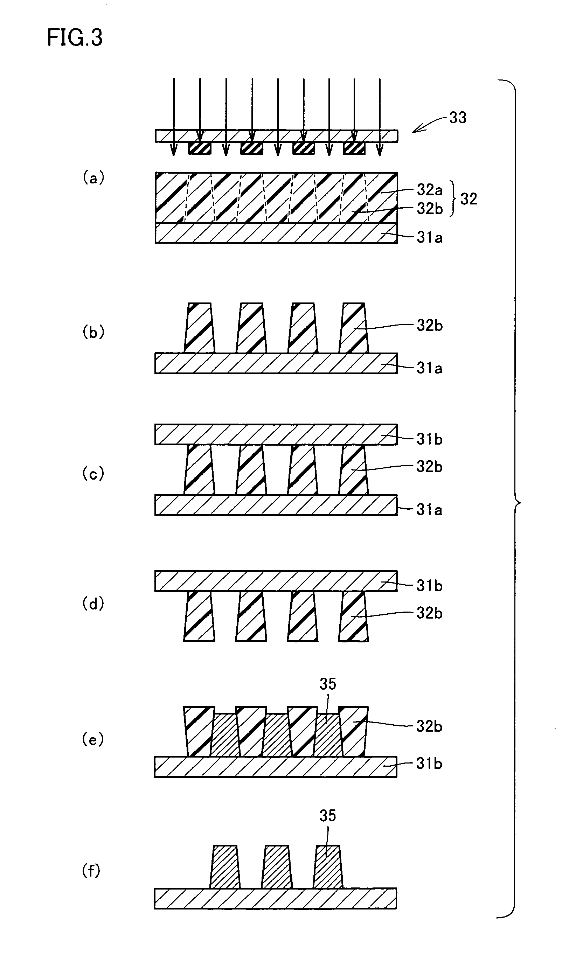

Figs. 2 and 3 illustrate a manufacturing method for the pressing die. In accordance with the manufacturing method for the pressing die shown in Fig. 2, first, a resist 22 is formed on a conductive substrate 21, as shown in Fig. 2(a). As the conductive substrate, a substrate made of a metal, such as, for example, copper, nickel or stainless steel, is used. Alternatively, a silicone substrate on which a metal material such as titanium or chromium has been sputtered may be used. As the resist, a resin material of which the main component is a polymethacrylate, for example, polymethyl methacrylate (PMMA) or an X-ray sensitive or ultraviolet ray (UV) sensitive chemical amplification type resin material is used. The thickness of the resist can be arbitrarily set in accordance with the height of the body in pillar form for the pressing die to be formed, and may be several hundreds of microns.

Next, a mask 23 is placed on resist 22, which is then irradiated with X-rays 24 or UV rays through mask 23. In a preferable embodiment, X-rays (wavelength: 0.4 nm) having a wavelength that is shorter than that of UV rays (wavelength: 365 nm or the like) are used in order to gain a pressing die having a high aspect ratio. In addition, an LIGA (Lithographie Galvanoformung Abformung) method using X-rays radiated from a synchrotron (hereinafter referred to as "SR"), which have higher directivity than other X-rays, makes deep lithography possible, and allows a large amount of microstructures having a height of several hundreds of µm to be manufactured with high precision on a sub-micron scale, and thus, is advantageous, in that a pressing die for a thick thin film made of a resin can be provided. An embodiment where X-rays are radiated is illustrated as the present embodiment.

Mask 23 is made of an X-ray absorbing layer 23a that has been formed in accordance with the pattern of the pressing die and a translucent base 23b. SiN, SiC, diamond, titanium or the like is used for translucent base 23b. In addition, a heavy metal, such as gold, tungsten or tantalum, or a compound thereof is used for X-ray absorbing layer 23a. In the case where resist 22 on conductive substrate 21 is, for example, a positive resist, resist 22a within resist 22 is exposed and changes in quality (molecular chains are cut) through radiation of X-rays 24, while resist 22b is not exposed, due to X-ray absorbing layer 23a. As a result, only the portion that has changed in quality due to X-rays 24 is removed as a result of development, and a resin die made of resist 22b as that shown in Fig. 2(b) is gained.

Next, electroforming is carried out, so that a metal material layer 25 is deposited on the resin die, as shown in Fig. 2(c). Electroforming means to form a layer made of a metal material on a conductive substrate using a metal ion solution. Electroforming is carried out using conductive substrate 21 as an electricity supplying portion, and thereby, metal material layer 25 can be deposited on the resin die. Nickel, copper, iron, rhodium or an alloy of these is used as the metal material, and nickel or a nickel alloy, such as nickel manganese, is preferable, in that the wear resistance of the pressing die is increased.

After electroforming, as shown in Fig. 2(d), wet etching is carried out using an acid or alkali, or mechanical processing is carried out, and thereby, conductive substrate 21 is removed. Subsequently, when resist 22b is removed by means of wet etching or plasma ashing, a pressing die which can be used in the processing method according to the present invention is gained, as shown in Fig. 2(e).

Though in accordance with the manufacturing method shown in Fig. 2, conductive substrate 21 is removed (Fig. 2(d)) and the pressing die is manufactured, a pressing die can be manufactured without removing the conductive substrate, as shown in Fig. 3. First, as shown in Fig. 3(a), a positive resist 32 is formed on a substrate 31a. Next, a mask 33 is placed on resist 32 and lithography is carried out in the same manner as described above. Resist 32a within resist 32 is exposed and changes in quality, while resist 32b is not exposed. As a result, a resin die made of resist 32b, as shown in Fig. 3(b), is gained, through development.

Next, as shown in Fig. 3(c), a conductive substrate 31b is formed on the top portion of resist 32b, substrate 31a is removed (Fig. 3(d)), electroforming is carried out, and as shown in Fig. 3(e), a metal material layer 35 is deposited on the resin die using conductive substrate 31b as a plating electrode. After electroforming, the layer is polished or shaved to a predetermined thickness, if necessary, and then, the resin die is removed by means of wet etching or plasma ashing, and thus, a pressing die as that shown in Fig. 3(f) is gained. In this pressing die, the conductive substrate is used as a support for the die, and therefore, the time for electroforming which would be required to form the support can be saved. In addition, the support is formed through electroforming, and therefore, only a slight amount of warping is caused in the die by internal stress.

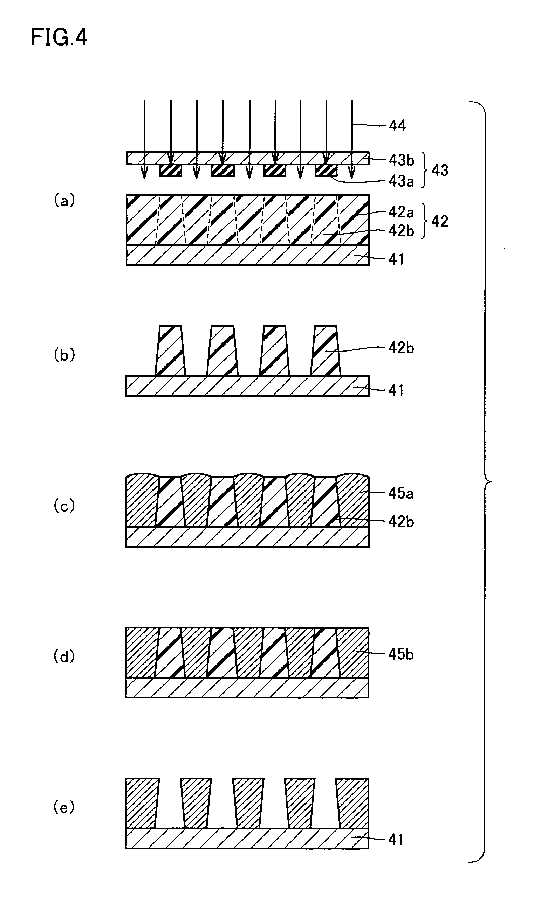

Fig. 4 shows another method for manufacturing a pressing die without removing the conductive substrate. This method can be used in the case where the material for the conductive substrate and the material for the metal material layer that is formed through electroforming are close in quality, and the adhesion between the conductive substrate and the metal material layer is great. First, lithography is carried out (Fig. 4(a)) in the same manner as in the method shown in Fig. 2, so that a resin die made of a resist 42b is formed on a conductive substrate 41 (Fig. 4(b)). Next, electroforming is carried out, so that a metal material layer 45a is formed on the resin die (Fig. 4(c)), and the layer is polished or shaved so as to be flattened (Fig. 4(d)). Finally, resist 42b is removed by means of wet etching or plasma ashing, so that a pressing die with conductive substrate 41 is gained, as shown in Fig. 4(e).

The pressing die can be formed in accordance with a method that includes the step of forming a non-conductive master by means of silicon etching or stereo lithography, the step of converting the non-conductive master to a conductive master, the step of forming a metal material layer on the conductive master through electroforming, and the step of removing the conductive master.

In accordance with the method for forming a non-conductive master by means of silicon etching, first, an SiN film is formed on the surface of a silicon substrate by means of plasma CVD. Next, a positive resist is formed on the SiN film. Subsequently, a mask is placed on the resist, and lithography is carried out. The exposed portion is removed from the resist through exposure and development. Next, dry etching is carried out using an SF₆ gas, so that the SiN film is patterned, and then, the resist is removed, and silicon etching is carried out using a KOH solution, so that a non-conductive master is gained. After that, a metal material, such as Pd, is sputtered so as to convert the non-conductive master to a conductive master, and the conductive master is removed by means of wet etching after electroforming, and thus, a conductive pressing die is gained.

In accordance with the method for forming a non-conductive master by means of stereo lithography, first, a UV curable resin (SCR701, made by D-MEC Ltd. or the like) in liquid form is cured layer by layer using a light beam in a microstereolithography apparatus so as to form layers, and thus, a non-conductive master is formed. Next, Pd or the like is sputtered on the non-conductive master, which is thus converted to a conductive master, electroforming is carried out on the conductive master, and the conductive master is removed by means of wet etching or plasma ashing, so that a conductive pressing die is gained.

The pressing die can be manufactured by means of dicing processing or cutting processing. Unlike the methods using lithography, this method does not use a mask, and therefore, allows for the manufacture of a pressing die in a short process.

The pressing die can be formed in accordance with a method that includes the step of forming a conductive master by means of dicing processing or cutting processing, the step of forming a metal material layer on the conductive master through electroforming, and the step of removing the conductive master. This is advantageous in that a number of pressing dies can be gained from an expensive product that has been dicing processed or cutting processed, as compared to the method for directly manufacturing a pressing die by means of dicing processing or cutting processing. The conductive master can be formed of, for example, copper or brass.

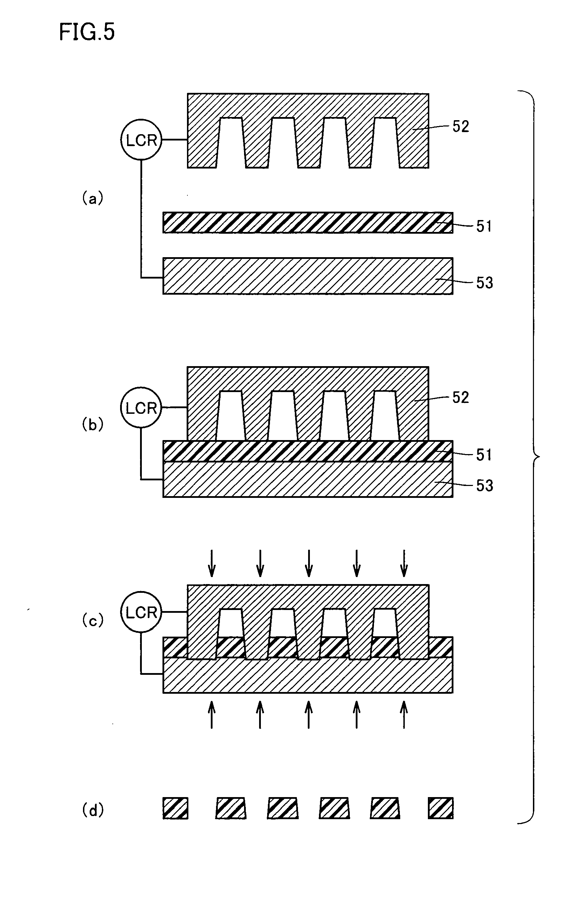

Fig. 5 illustrates a preferable processing method according to the present invention, where the distance between the pressing die and the facing base is detected. In accordance with this processing method, first, as shown in Fig. 5(a), a measuring instrument for measuring capacitance and electrical resistance, such as an LCR meter, is connected to a conductive pressing die 52 and a facing base 53, and a thin film made of a resin 51 is placed between conductive pressing die 52 and facing base 53. Next, as shown in Fig. 5(b), thin film made of a resin 51 is heated between pressing die 52 and facing base 53. After that, as shown in Fig. 5(c), pressure is applied to the heated thin film made of a resin between the pressing die and the facing base in the direction of the arrow, and therefore, a microstructure is formed, as shown in Fig. 5(d). According to the present invention, the distance between pressing die 52 and facing base 53 is detected by measuring the capacitance of thin film made of a resin 51 in this processing method. Alternatively, the distance between pressing die 52 and facing base 53 is detected by measuring the electrical resistance of the thin film made of a resin.

The capacitance and the electrical resistance can be measured using the LCR meter (reactance capacitance resistance meter). The capacitance and the electrical resistance of a condenser where a sample is placed is measured using the LCR meter, and the complex dielectric constant can be evaluated at this frequency. As the LCR meter, HP4284A, made by Agilent Technologies Co., Ltd. and the like can be cited, and HP4284A can measure at 20 Hz to 1 MHz.

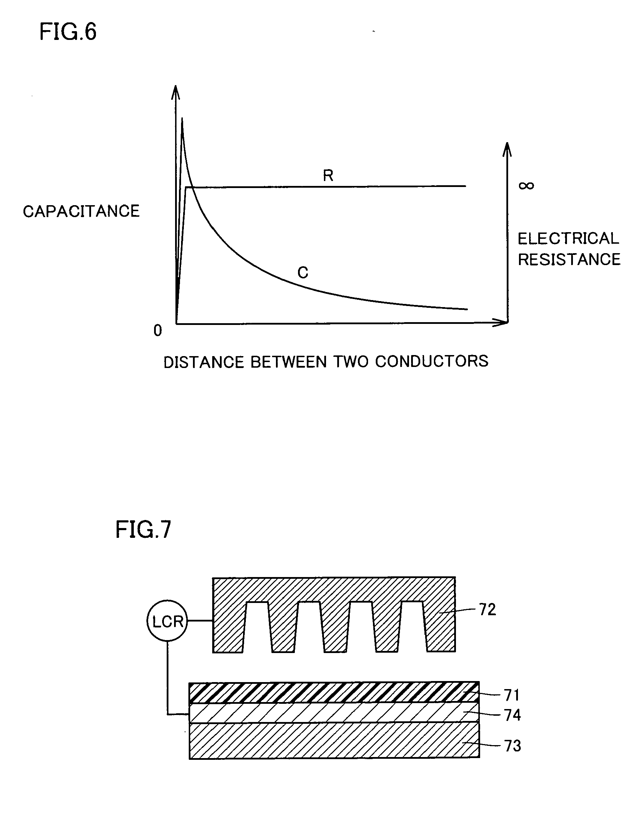

Capacitance is the capacity for storing electrical energy, and is a value for indicating how much charge Q can be stored for a certain difference in potential V. When an insulator is inserted between two conductors, the insulator absorbs electrical energy so as to change the orientation of molecules, and therefore, more electrical energy is required to maintain a constant difference in potential, and thus, the capacitance between the two conductors increases. When a thin film made of a resin, which is an insulator, is placed between two conductors, and the entirety is molded by applying pressure, the distance between the two conductors becomes gradually smaller, and the form of the thin film made of a resin between the two conductors changes, and therefore, the capacitance increases, as shown in Graph C in Fig. 6. When the distance between the conductors becomes still smaller and a through-hole is formed in the thin film made of a resin, the two conductors make contact with each other and become conductive, and therefore, the capacitance is lowered. Accordingly, even in the case where there is inconsistency in the thickness of the thin film made of a resin, it is possible to detect, and in addition, to control the distance between the two conductors and the formation of a through-hole with high precision in line, by monitoring the capacitance between the two conductors. Therefore, a microstructure of which the total thickness is controlled with high precision can be manufactured with high reproducibility.

In addition, the electrical resistance of the thin film made of a resin becomes 0, as shown in Graph R of Fig. 6, when a through-hole is formed by applying pressure, and the distance between the two conductors becomes 0 and the two become conductive. Accordingly, the timing with which the distance between the two conductors becomes 0 and a through-hole is formed can be found by monitoring the electrical resistance. In addition, this can be used together with the system for detecting the capacitance, and thereby, the precision of detection can further be increased, and response increased. In addition, this detection apparatus is very inexpensive.

As shown in Fig. 5(a), conductive pressing die 52 and conductive facing base 53, for example, are used as the two conductors, the two are connected via an LCR meter, and the capacitance and the electrical resistance of thin film made of a resin 51, which is a plastic thin film, are measured, and thereby, the distance between conductive pressing die 52 and conductive facing base 53 and the state of processing of thin film made of a resin 51 can be detected.

In addition, as shown in Fig. 7, microscopic processing of a thin film made of a resin 71, which is, for example, a resist, is possible in an embodiment where a circuit substrate 74 is installed on top of facing base 73, and thin film made of a resin 71 is applied to circuit substrate 74, that is to say, in an embodiment where facing base 73 is provided with circuit substrate 74 between facing base 73 and thin film made of a resin 71. In this embodiment, the circuit electrode (not shown) of circuit substrate 74 and conductive pressing die 72 are used as the conductors, the two are connected via an LCR meter, and the capacitance and the electrical resistance of thin film made of a resin 71 are detected, and thereby, the distance between the conductors, the distance between the pressing die and the facing base, and the state of processing can be found. In addition, a conductive facing base is used, so that the conductive pressing die and the conductive facing base are connected via an LCR meter, and thereby, the processing state of the thin film made of a resin on the circuit substrate can be found. Accordingly, the facing base may be made of a metal. Alternatively, a facing base made of a ceramic, plastic or silicone may be used with a circuit electrode of the circuit substrate.

### (Processing Apparatus)

A processing apparatus of the present invention is characterized by being provided with a means for placing a thin film made of a resin between a pressing die and a facing base, a means for heating the thin film made of a resin between the pressing die and the facing base to a temperature that is no lower than the temperature at which the resin starts being liquefied, and a means for forming a through-hole by applying pressure to the thin film made of a resin of which the temperature is no lower than the temperature at which the resin starts being liquefied between the pressing die and the facing base. A thin film made of a resin is heated to a temperature that is no lower than the temperature at which the resin starts being liquefied before being processed, and therefore, a highly precise ultramicroscopic through-hole can be easily formed in the thin film made of a resin, and the manufacturing cost is low.

It is preferable in the means for forming a through-hole for the maximum difference in the pressure within the surface at the time when pressure is applied to be no greater than +/- 10 %, because it becomes difficult for non-penetrating holes to be created, even when a great number of microscopic holes are collectively processed within the surface, and it is more preferable for the maximum difference in the pressure within the surface to be adjusted to no greater than +/- 5 %.

It is preferable for the means for forming a through-hole to be a means for cooling the thin film made of a resin and at least one of the pressing die and the facing base after the formation of a through-hole. After the formation of a through-hole, the members of which the temperature is no lower than the temperature where the resin starts being liquefied are cooled, so that the solidification of the resin accelerates, and thereby, the throughput of processing can be increased, and mass production and reduction in cost can be achieved. For the cooling, a means for making cooled water circulate through the facing base can be used. Alternatively, the heating stage beneath the facing base may be replaced with a cooling stage, and cooling may be carried out using a means for making the cooling stage make contact with the facing base.

It is preferable for the means for placing a thin film made of a resin between a pressing die and a facing base, the means for heating a thin film made of a resin, and the means for forming a through-hole in a thin film made of a resin to have independent driving systems. The driving systems of the respective means are separated from each other, and therefore, positional shift between the respective means caused by repeated operation during the process can be kept to the minimum, and it becomes easy to always make the maximum difference within the surface no greater than +/- 10 %. The X axis stage, the Y axis stage and the Z axis stage in the processing apparatus are placed so as not to overlap with each other, for example, and the precision can be increased by separating these from each other.

It is preferable for the means for placing a thin film made of a resin between a pressing die and a facing base, the means for heating a thin film made of a resin, and the means for forming a through-hole in a thin film made of a resin to be placed within a vacuum chamber. Processing work is carried out in a vacuum, and therefore, the thin film made of a resin can be prevented from lifting off from the facing base, so that bubbles are prevented from being mixed in between the thin film made of a resin and the facing base, making the creation of clean holes possible in the process.

It is preferable for the processing apparatus of the present invention to be provided with a means for detecting the distance between the conductive pressing die and the facing base by measuring the capacitance of the thin film made of a resin. In addition, it is preferable for the processing apparatus for the present invention to be provided with a means for detecting the distance between the conductive pressing die and the facing base by measuring the electrical resistance of the thin film made of a resin. In such a processing apparatus, the distance between the conductive pressing die and the facing base, as well as the state of processing, can be detected with high precision in-line, and therefore, a microstructure of which the thickness has been adjusted with high precision and a microstructure in which a through-hole has been formed can be easily manufactured, and the manufacturing cost is low.

### (Example 1)

The pressing die used in the present example was manufactured in accordance with the method shown in Fig. 4. First, a resist 42 was formed of an acryl resin having a thickness of 60 µm on a nickel substrate having a thickness of 5 mm and a diameter of 3 inches, which is a conductive substrate 41, and a mask 43 was placed on resist 42, so that X-rays 44 were radiated through mask 43 (Fig. 4(a)). A mask 43 where translucent regions of 25 µm × 25 µm are created with a pitch of 50 µm longitudinally and laterally, a translucent base 43b is made of silicon nitride having a thickness of 2 µm, and an X-ray absorbing layer 43a is made of tungsten nitride having a thickness of 3 µm was used as mask 43. In addition, SR was used as X-rays 44, and lithography was carried out in an area of 50 mm × 50 mm.

Next, the substrate was developed using methyl isobutyl ketone, followed by rinsing processing using isopropanol, and after that, washed with pure water, and then, only exposed resist 42a was removed from resist 42, and a resin die made of resist 42b as that shown in Fig. 4(b) was gained. Next, electroforming was carried out, so that a metal material layer 45a deposited on the resin die, as shown in Fig. 4(c). Electroforming was carried out by immersing the resin die in a nickel sulfamate plating bath, so that metal material layer 45a deposited in such a manner as to bulge over the top portion of the resin die.

After electroforming, as shown in Fig. 4(d), the metal material layer was flattened through polishing to a thickness of 50 µm, and subsequently, ashing was carried out using oxygen plasma so as to remove resist 42b, and thus, a pressing die as that shown in Fig. 4(e) was gained. In this pressing die, prisms 45b having a width of 25 µm × a length of 25 µm × a height of 50 µm stood close together in an area of 50 mm × 50 mm with a pitch of 50 µm, and each prism has an outward taper of 0.1 °.

Next, as shown in Fig. 5(a), thermoplastic polyimide (Aurum made by Mitsui Chemicals, Inc.) was applied to a Cu substrate, which is facing base 53, and dried, so as to form a thin film of a resin 51 having a thickness of 30 µm. Subsequently, an LCR meter was connected to the above described pressing die 52 made ofNi that was manufactured in accordance with an LIGA method, and facing base 53, and after that, a pressing die 52 is placed on thin film made of a resin 51, and thin film made of a resin 51 was heated to 260°C, which is not lower than the temperature at which thermoplastic polyimide starts being liquefied (approximately 245°C) (Fig. 5(b)). Thin film made of a resin 51 was heated using a heater (not shown) installed directly beneath facing base 53. After that, pressure of 10 MPa was applied to thin film made of a resin 51 between pressing die 52 and facing base 53 while monitoring the capacitance and the electrical resistance of thin film made of a resin 51, so that through-holes were formed (Fig. 5(c)), and after cooling, pressing die 52 and facing base 53 were removed, and thus, a microstructure having through-holes was gained (Fig. 5(d)).

4284A, made by Agilent Technology, was used as the LCR meter (which is the same in following examples), and the capacitance and the electrical resistance were measured and monitored at a voltage of 1 V and a frequency of 1 kHz. The results show the tendency shown in Fig. 6, where capacitance C was 1.5 µF before application of pressure (distance between conductors: 30 µm), after the two conductors, the pressing die and the facing base, were placed on the thin film made of a resin, and gradually increased as pressure was applied, reaching a maximum value of 20 µF when the distance between the conductors was 1 µm, and after that, suddenly decreased to 0 µF at the time of formation of through-holes (distance between conductors: 0 µm). Accordingly, it was found that the distance between the conductors could be detected, and the total thickness of the thin film made of a resin could be adjusted by measuring the capacitance.

Meanwhile, electrical resistance R of the thin film made of a resin was ∞Ω before applying pressure, and after that, decreased suddenly to 0 Ω at the time of formation of through-holes (distance between conductors: 0 µm). Accordingly, it was found that the timing with which the distance between the conductors become 0 and through-holes are formed can be predicted by measuring the electrical resistance. The through-holes had a width of 25 µm × a length of 25 µm × a depth of 50 µm with a pitch of 50 µm. In addition, the precision in processing was +/- 1 µm, and it was found that processing could be carried out with very high precision.

### (Example 2)

As shown in Fig. 5(a), a polycarbonate film (FS-1650, made by Sumitomo Bakelite Co., Ltd.) having a thickness of 30 µm as thin film made of a resin 51 was placed on a substrate made of copper, which is facing base 53. Next, a pressing die made of a hard metal where prisms having a width of 50 µm × a length of 50 µm × a height of 100 µm stand close together was fabricated through dicing, and an LCR meter was connected to the fabricated pressing die 52 and facing base 53, and after that, pressing die 52 was placed on thin film made of a resin 51. Subsequently, thin film made of a resin 51 was heated to 160°C, which is not lower than the temperature where thin film made of a polycarbonate resin 51 starts being liquefied (approximately 145°C) (Fig. 5(b)). Thin film made of a resin 51 was heated using a heater installed directly beneath facing base 53. After that, pressure of 10 MPa was applied to thin film made of a resin 51 between pressing die 52 and facing base 53 while monitoring the capacitance and the electrical resistance of thin film made of a resin 51, so that through-holes were formed (Fig. 5(c)), and after cooling, pressing die 52 and facing base 53 were removed, and thus, a microstructure having through-holes was gained (Fig. 5(d)).

The capacitance and the electrical resistance were measured and monitored using an LCR meter at a voltage of 1 V and a frequency of 1 kHz. The results show the tendency shown in Fig. 6, where capacitance C is 1.3 µF before applying pressure (distance between conductors: 30 µm) after the two conductors, the pressing die and the facing base, were placed on the thin film made of a resin, and gradually increases as pressure is applied, reaching a maximum value of 17 µF when the distance between conductors was 1 µm, and after that, suddenly decreases to 0 µF at the time of formation of through-holes (distance between conductors: 0 µm). Accordingly, it was found that the distance between the conductors could be known and the total thickness of the thin film made of a resin could be adjusted by detecting the capacitance.

Meanwhile, electrical resistance R of the thin film made of a resin was ∞Ω before applying pressure, and after that, decreased suddenly to 0 Ω at the time of formation of through-holes (distance between conductors: 0 µm). Accordingly, it was found that the timing with which the distance between the conductors become 0 and through-holes are formed can be predicted by measuring the electrical resistance. The through-holes had a width of 50 µm × a length of 50 µm × a depth of 60 µm. In addition, the precision in processing was +/- 2 µm.

### (Example 3)

A polycarbonate film (FS-1650, made by Sumitomo Bakelite Co., Ltd.) having a thickness of 30 µm as a thin film made of a resin was placed on an aluminum nitride substrate, which is a facing base, having a Vickers hardness of 1800. Next, a pressing die made of zirconia where prisms having a width of 50 µm × a length of 50 µm × a height of 100 µm stand close together, was fabricated through dicing, and the fabricated pressing die was placed on the thin film made of a resin.

The Vickers hardness of this pressing die was 1200. Subsequently, the thin film made of a resin was heated to 160°C, which is not lower than the temperature at which the thin film made of a polycarbonate resin starts being liquefied (approximately 145°C). The thin film made of a resin was heated using a heater installed directly beneath the facing base. After that, pressure of 10 MPa was applied to the thin film made of a resin between the pressing die and the facing base, so that through-holes were formed. The formed through-holes had a width of 50 µm × a length of 50 µm × a depth of 60 µm, and neither damage nor deformation was evident on the pressing die and the facing base at the time of processing.

### (Example 4)

A thin film was processed in the same manner as in Example 3, except that a pressing die made of a hard metal having a Vickers hardness of 600 was used instead of the pressing die made of Zirconia having a Vickers hardness of 1200. As a result, through-holes having a width of 50 µm × a length of 50 µm × a depth of 60 µm were formed, and neither damage nor deformation was evident on the pressing die and the facing base at the time of processing.

The examples disclosed herein are illustrative in all respects, and should not be considered as being limitative. The scope of the present invention is not defined by the above description, but by the claims, and is intended to include meanings which are equivalent to the claims and all the modifications within the scope.

### Industrial Applicability

A microstructure having high performance, such as a nozzle for an inkjet printer, a medical nebulizer nozzle, a precise filter for ultramicroscopic fillers, a micro lens or a high density printed circuit board can be provided at low cost.

## Claims

1. A processing method for a thin film made of a resin according to which a microscopic through-hole is formed in a thin film made of a resin (1), **characterized by** comprising the steps of:
placing a thin film made of a resin (1) between a pressing die (2) and a facing base (3);
heating the thin film made of a resin (1) between a pressing die (2) and a facing base (3) to a temperature that is no lower than the temperature at which the resin starts being liquefied; and
applying pressure to the thin film made of a resin (1) at a temperature that is no lower than the temperature at which the resin starts being liquefied, so that a through-hole is formed.

2. The processing method according to Claim 1, wherein said pressing die (2) is made of a metal or a ceramic, and said facing base (3) is made of a metal, a ceramic, a plastic or silicone.

3. The processing method according to Claim 1, wherein said pressing die (2) has a Vickers hardness of no less than 400.

4. The processing method according to Claim 1, wherein said pressing die (2) is manufactured in accordance with a method comprising the steps of:
forming a resin die by means of lithography;
forming a layer made of a metal material on said resin die on a conductive substrate by means of electroforming; and
removing said resin die.

5. The processing method according to Claim 1, wherein said pressing die (2) is manufactured in accordance with dicing processing.

6. The processing method according to Claim 1, wherein said pressing die (2) is manufactured in accordance with cutting processing.

7. The processing method according to Claim 1, wherein said facing base (3) is made of a material selected from among alumina, aluminum nitride, silicon nitride, silicon carbide and tungsten carbide.

8. The processing method according to Claim 1, wherein the Young's modulus of said facing base (3) is no less than 0.1 GPa and no greater than 300 GPa at the time of said heating processing.

9. The processing method according to Claim 1, wherein the Vickers hardness of said facing base (3) is no less than 0.5 times and no greater than 3.0 times the Vickers hardness of the pressing die (2).

10. The processing method according to Claim 1, wherein said step of placing a thin film made of a resin (1) between a pressing die (2) and a facing base (3) comprises the steps of:
fixing the thin film made of a resin (1) on the facing base (3); and
placing the pressing die (2) on the fixed thin film made of a resin (1).

11. The processing method according to Claim 1, wherein said step of forming a through-hole comprises the step of exchanging the used facing base (3) with a new facing base after the formation of a through-hole.

12. The processing method according to Claim 1, wherein the thin film made of a resin (1) and/or the facing base (3) are supplied from a reel and wound around a reel.

13. The processing method according to Claim l, wherein the sequence of steps, starting from the step of placing a thin film made of a resin (1), through to the step of heating, and on to the step of forming a through-hole, is carried out in a vacuum.

14. The processing method according to Claim 1, **characterized in that** the distance between the conductive pressing die (2) and the facing base (3) is detected by measuring the capacitance of said thin film made of a resin (1).

15. The processing method according to Claim 14, wherein said facing base (3) is conductive.

16. The processing method according to Claim 14, wherein said facing base (73) comprises a circuit substrate (74) between the facing base (73) and the thin film made of a resin (71).

17. The processing method according to Claim 1, **characterized in that** the distance between the conductive pressing die (2) and the facing base (3) is detected by measuring the electrical resistance of said thin film made of a resin (1).

18. The processing method according to Claim 17, wherein said facing base (3) is conductive.

19. The processing method according to Claim 17, wherein said facing base (73) comprises a circuit substrate (74) between the facing base (73) and the thin film made of a resin (71).

20. A processing apparatus for forming a microscopic through-hole in a thin film made of a resin (1), **characterized by** comprising:
a means for placing a thin film made of a resin (1) between a pressing die (2) and a facing base (3);
a means for heating the thin film made of a resin (1) between the pressing die (2) and the facing base (3) to a temperature that is no lower than the temperature at which the resin starts being liquefied; and
a means for forming a through-hole by applying pressure to the thin film made of a resin (1) at a temperature that is no lower than the temperature at which the resin starts being liquefied between the pressing die (2) and the facing base (3).

21. The processing apparatus according to Claim 20, wherein the maximum difference in the pressure within the surface at the time of said application of pressure is no greater than +/- 10 % in said means for forming a through-hole.

22. The processing apparatus according to Claim 20, wherein said means for forming a through-hole has a means for cooling at least one of the thin film made of a resin (1), the pressing die (2) and the facing base (3) after the formation of the through-hole.

23. The processing apparatus according to Claim 20, wherein the means for placing the thin film made of a resin (1), the means for heating the thin film made of a resin (1) and the means for forming a through-hole in the thin film made of a resin (1) are placed within a vacuum chamber.

24. The processing apparatus according to Claim 20, **characterized by** further comprising a means for detecting the distance between the conductive pressing die (2) and the facing base (3) by measuring the capacitance of said thin film made of a resin (1).

25. The processing apparatus according to Claim 20, **characterized by** further comprising a means for detecting the distance between the conductive pressing die (2) and the facing base (3) by measuring the electrical resistance of said thin film made of a resin (1).

26. A microstructure manufactured in accordance with the method according to Claim 1, which is **characterized by** being a medical nebulizer nozzle.

27. A microstructure manufactured in accordance with the method according to Claim 1, which is **characterized by** being a nozzle for an inkjet printer.

28. A microstructure manufactured in accordance with the method according to Claim 1, which is **characterized by** being a microscopic circuit on a high density printed circuit board.

29. A microstructure manufactured in accordance with the method according to Claim 1, which is **characterized by** being a filter for capturing cells.

30. A microstructure manufactured in accordance with the method according to Claim l, which is **characterized by** being a filter for ultramicroscopic fillers.
